(19) Europäisches Patentamt
European Patent Office
Office européen des brevets

(11) **EP 4 696 822 A1**

(12) **EUROPEAN PATENT APPLICATION**

(43) Date of publication:
**18.02.2026 Bulletin 2026/08**

(51) International Patent Classification (IPC):
***C30B 29/36*** (2006.01)   ***C30B 23/06*** (2006.01)

(21) Application number: **25189895.3**

(52) Cooperative Patent Classification (CPC):
**C30B 29/36; C30B 23/06; C30B 23/063**

(22) Date of filing: **16.07.2025**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **22.07.2024 JP 2024117184**

(71) Applicant: **Resonac Corporation
Tokyo 105-7325 (JP)**

(72) Inventor: **NOGUCHI, Shunsuke
Tokyo, 105-7325 (JP)**

(74) Representative: **Strehl & Partner mbB
Maximilianstrasse 54
80538 München (DE)**

(54) **SIC SINGLE CRYSTAL, SIC SUBSTRATE AND SIC EPITAXIAL WAFER**

(57)    A SiC single crystal according to an embodiment has a lattice surface measured along each of a first straight line, a second straight line, a third straight line, a fourth straight line, a fifth straight line and a sixth straight line, which is curved in a convex shape. In the lattice surface measured along each of the first straight line, the second straight line, the third straight line, the fourth straight line, the fifth straight line and the sixth straight line, the center is located closer to a C surface than an end portion of the lattice surface measured along each of the straight lines. Each of the first straight line, the second straight line, the third straight line, the fourth straight line, the fifth straight line and the sixth straight line is a straight line passing through the center when seen in a plan view in a thickness direction and inclined by 30° each based on the center.

FIG. 2

EP 4 696 822 A1

**Description**

CROSS-REFERENCE TO RELATED APPLICATION

Priority is claimed on Japanese Patent Application No. 2024-117184, filed July 22, 2024, the content of which is incorporated herein by reference.

BACKGROUND

Field

The present invention relates to a SiC single crystal, a SiC substrate and a SiC epitaxial wafer.

Description of Related Art

Silicon carbide (SiC) has a dielectric breakdown field slightly larger and a band gap three times larger than those of silicon (Si). In addition, silicon carbide (SiC) has a thermal conductivity about three times higher than that of silicon (Si). For this reason, silicon carbide (SiC) is expected to be used in power devices, high frequency devices, or the like. In addition, silicon carbide (SiC)-based devices can operate in temperature ranges as high as 150°C or higher. For this reason, in recent years, SiC epitaxial wafers have been used for the above-mentioned semiconductor devices.
SiC epitaxial wafers are obtained by laminating a SiC epitaxial layer on a surface of a SiC substrate. Hereinafter, a substrate before lamination of the SiC epitaxial layer is referred to as a SiC substrate, and the substrate after lamination of the SiC epitaxial layer is referred to as a SiC epitaxial wafer. The SiC substrate is cut from a SiC ingot. The SiC ingot is a crystal growth of a single SiC crystal on a seed crystal.
SiC single crystals are required to be of high quality with few defects and dislocations. Patent Document 1 discloses that there is a correlation between a curvature of a lattice surface of a SiC single crystal and a basal plane dislocation (BPD) density.

[Patent Documents]

[Patent Document 1] Japanese Unexamined Patent Application, First Publication No. 2020-26373

SUMMARY

The basal plane dislocation (BPD) density changes as crystal growth progresses. For example, when the SiC single crystal is grown on a C surface, the basal plane dislocation density differs between the Si surface and the C surface. If the basal plane dislocation density on the C surface can be made lower than the basal plane dislocation density on the Si surface, the SiC substrate cut out from near the C surface will be of high quality with a low basal plane dislocation density.
In consideration of the above-mentioned problems, the present disclosure is directed to providing a SiC single crystal capable of reducing a basal plane dislocation density on a C surface.
As a result of extensive investigation, the inventors found that a warp of a lattice surface of a SiC single crystal influenced a change in basal plane dislocation density and threading dislocation density within the SiC single crystal. The warp of the lattice surface of the SiC single crystal changes due to the influence of internal stress that occurs during crystal growth and cooling of the SiC single crystal, and therefore, does not necessarily coincide with the external form of the SiC single crystal (for example, the final shape of the crystal growth surface of the SiC single crystal). That is, it is not possible to determine the warp of the SiC lattice surface from the external form of the SiC single crystal. Simply controlling the external form of the SiC single crystal does not completely control the warp of the SiC lattice surface, and the basal plane dislocation density and the threading dislocation density on the C surface cannot be sufficiently reduced. It was found that the present disclosure can control the warp of the lattice surface of the SiC single crystal and reduce the basal plane dislocation density and the threading dislocation density on the C surface. That is, the present disclosure provides the following means to solve the above-mentioned problems.

(1) A SiC single crystal according to a first aspect has a lattice surface measured along each of a first straight line, a second straight line, a third straight line, a fourth straight line, a fifth straight line and a sixth straight line, which is curved in a convex shape. The lattice surface measured along each of the first straight line, the second straight line, the third straight line, the fourth straight line, the fifth straight line and the sixth straight line, having a center located closer to a C surface than an end portion of the lattice surface measured along each of the straight lines, the first straight line being a straight line passing through the center when seen in a plan view in a thickness direction, the second straight line being a straight line passing through the center and inclined 30° from the first straight line based on the center, the third straight line being a straight line passing through the center and inclined 60° from the first straight line based on the center, the fourth straight line being a straight line passing through the center and inclined 90° from the first straight line based on the center, the fifth straight line being a straight line passing through the center and inclined 120° from the first straight line based on the center, and the sixth straight line being a straight line passing through the center and inclined 150° from the first straight line based on the center.

(2) In the SiC single crystal according to the above-mentioned aspect, a main surface may have an offset angle with respect to a (0001) plane. In this case, the first straight line is a straight line extending in a <11-20> direction.

(3) In the SiC single crystal according to the above-mentioned aspect, provided that a diameter when seen in a plan view in a thickness direction is d, a maximum diffraction peak angle of a (0004) plane at the center is $\omega_0$, and a maximum diffraction peak angle of the (0004) plane at a measurement point separated by d/3 from the center is $\omega_1$, in X-ray diffraction results measured along each of the first straight line, the second straight line, the third straight line, the fourth straight line, the fifth straight line and the sixth straight line, $(\omega_1-\omega_0)/(d/3) < -2.00\times10^{-6}$ may be satisfied.

(4) In the SiC single crystal according to the above-mentioned aspect, in the X-ray diffraction results measured along each of the first straight line, the second straight line, the third straight line, the fourth straight line, the fifth straight line and the sixth straight line, $(\omega_1-\omega_0)/(d/3) < -3.00\times10^{-6}$ may be satisfied.

(5) **In** the SiC single crystal according to the above-mentioned aspect, in the X-ray diffraction results measured along each of the first straight line, the second straight line, the third straight line, the fourth straight line, the fifth straight line and the sixth straight line, $(\omega_1-\omega_0)/(d/3) < -4.00\times10^{-6}$ may be satisfied.

(6) **In** the SiC single crystal according to the above-mentioned aspect, provided that a diameter when seen in a plan view in a thickness direction is d, in the X-ray diffraction results measured along each of the first straight line, the second straight line, the third straight line, the fourth straight line, the fifth straight line and the sixth straight line, a half width of a maximum diffraction peak in a (0004) plane at a measurement point separated by d/3 from the center may be less than $5.20\times10^{-2}$.

(7) **In** the SiC single crystal according to the above-mentioned aspect, in the X-ray diffraction results measured along each of the first straight line, the second straight line, the third straight line, the fourth straight line, the fifth straight line and the sixth straight line, a half width of a maximum diffraction peak in a (0004) plane at a measurement point separated by d/3 from the center may be less than $4.80\times10^{-2}$.

(8) **In** the SiC single crystal according to the above-mentioned aspect, in the X-ray diffraction results measured along each of the first straight line, the second straight line, the third straight line, the fourth straight line, the fifth straight line and the sixth straight line, a half width of a maximum diffraction peak of a (0004) plane at a measurement point separated by d/3 from the center may be less than $4.40\times10^{-2}$.

(9) In the SiC single crystal according to the above-mentioned aspect, provided that a basal plane dislocation density on a Si surface is $BPD_0$ and a basal plane dislocation density on a C surface is $BPD_1$, $(BPD_0-BPD_1)/BPD_0 > 64\%$ may be satisfied.

(10) In the SiC single crystal according to the above-mentioned aspect, provided that a threading screw dislocation density on a Si surface is $TSD_0$ and a threading screw dislocation density on a C surface is $TSD_1$, $(TSD_0-TSD_1)/TSD_0 > 48.2\%$ may be satisfied.

(11) In the SiC single crystal according to the above-mentioned aspect, provided that a basal plane dislocation density on a Si surface is $BPD_0$, a basal plane dislocation density on a C surface is $BPD_1$, a threading screw dislocation density on a Si surface is $TSD_0$, a threading screw dislocation density on a C surface is $TSD_1$, and a crystal length in a thickness direction is T, $(BPD_0-BPD_1)/(BPD_0\times T) > 1\%/mm$ may be satisfied, and $(TSD_0-TSD_1)/(TSD_0\times T) > 1\%/mm$ may be satisfied.

(12) In the SiC single crystal according to the above-mentioned aspect, $(BPD_0-BPD_1)/(BPD_0\times T) > 2\%/mm$ may be satisfied, and $(TSD_0-TSD_1)/(TSD_0\times T) > 2\%/mm$ may be satisfied.

(13) In the SiC single crystal according to the above-mentioned aspect, $(BPD_0-BPD_1)/(BPD_0\times T) > 3\%/mm$ may be satisfied, and $(TSD_0-TSD_1)/(TSD_0\times T) > 3\%/mm$ may be satisfied.

(14) In the SiC single crystal according to the above-mentioned aspect, a diameter when seen in a plan view in a thickness direction may be equal to or greater than 145 mm.

(15) In the SiC single crystal according to the above-mentioned aspect, a diameter when seen in a plan view in a thickness direction may be equal to or greater than 195 mm.

(16) In the SiC single crystal according to the above-mentioned aspect, a diameter when seen in a plan view in a thickness direction may be equal to or greater than 295 mm.

(17) In the SiC single crystal according to the above-mentioned aspect, a basal plane dislocation density on a C surface may be less than 500 pieces/cm$^2$.

(18) In the SiC single crystal according to the above-mentioned aspect, a threading screw dislocation density on a C surface may be less than 300 pieces/cm$^2$.

(19) In the SiC single crystal according to the above-mentioned aspect, a etch pit density on a C surface may be less

than 4000 pieces/cm$^2$.

(20) A SiC substrate according to a second aspect includes the SiC substrate according to the above-mentioned aspect.

(21) A SiC epitaxial wafer according to a third aspect includes the SiC substrate according to the above-mentioned aspect; and a SiC epitaxial layer formed on one surface of the SiC substrate.

The SiC single crystal according to the above-mentioned aspects can reduce the basal plane dislocation density on the C surface.

BRIEF DESCRIPTION OF THE DRAWINGS

FIG. 1 is a perspective view of a SiC single crystal according to an embodiment.

FIG. 2 is a plan view of the SiC single crystal according to the embodiment.

FIG. 3 is a cross-sectional view of characteristic parts of the SiC single crystal according to the embodiment.

FIG. 4 is a perspective view of an example of a lattice surface of the SiC single crystal according to the embodiment.

FIG. 5 is a perspective view of an example of a lattice surface of a SiC single crystal according to a first comparative example.

FIG. 6 is a perspective view of an example of a lattice surface of a SiC single crystal according to a second comparative example.

FIG. 7 is a cross-sectional view before crystal growth of an apparatus for manufacturing the SiC single crystal according to the embodiment.

FIG. 8 is a cross-sectional view of a holding member of the apparatus for manufacturing the SiC single crystal according to the embodiment.

FIG. 9 is a cross-sectional view of crystal growth of the apparatus for manufacturing the SiC single crystal according to the embodiment.

FIG. 10 is a cross-sectional view of another example of the holding member of the apparatus for manufacturing the SiC single crystal according to the embodiment.

DETAILED DESCRIPTION OF THE INVENTION

Hereinafter, a SiC single crystal according to an embodiment will be described with reference to the accompanying drawings as appropriate. The drawings used in the following description may show enlarged characteristic parts for the sake of convenience in order to make the features of the embodiment easier to understand, and dimensional ratios of each component may differ from the actual ones. The materials, dimensions, or the like, exemplified in the following description are merely examples, and the present invention is not limited to them, and can be modified as appropriate within the scope that does not change the spirit of the invention.

In this specification, an individual direction is indicated by [], a collective direction is indicated by <>, an individual plane is indicated by (), and a collective plane is indicated by {}. For negative exponents, in crystallography a "-" (bar) is placed above the number, but in this specification, a negative sign is placed before the number.

First, directions will be defined. A thickness direction (crystal growth direction) of the SiC single crystal is referred to as a Z direction. The Z direction may be a <0001> direction, and may be inclined by an offset angle with respect to the <0001> direction. For example, a +Z direction is referred to as a [000-1] direction, and a -Z direction is referred to as a [0001] direction. A main surface in the [000-1] direction with reference to a center of the SiC single crystal in the thickness direction is a C surface, and the main surface in the [0001] direction is a Si surface. One direction of the surface perpendicular to the Z direction is referred to as an X direction. The X direction is, for example, a <11-20> direction. For example, a -X direction with reference to the center is referred to as a [11-20] direction, and a +X direction is referred to as a [-1-120] direction. The -X direction is an offset upstream side in the case of offset growth, and the +X direction is an offset downstream side in the case of the offset growth. In addition, in the surface perpendicular to the Z direction, a direction perpendicular to the X direction is referred to as a Y direction. The Y direction is, for example, a <1-100> direction. For example, a +Y direction with reference to the center is referred to as a [1-100] direction, and a -Y direction is referred to as a [-1100] direction.

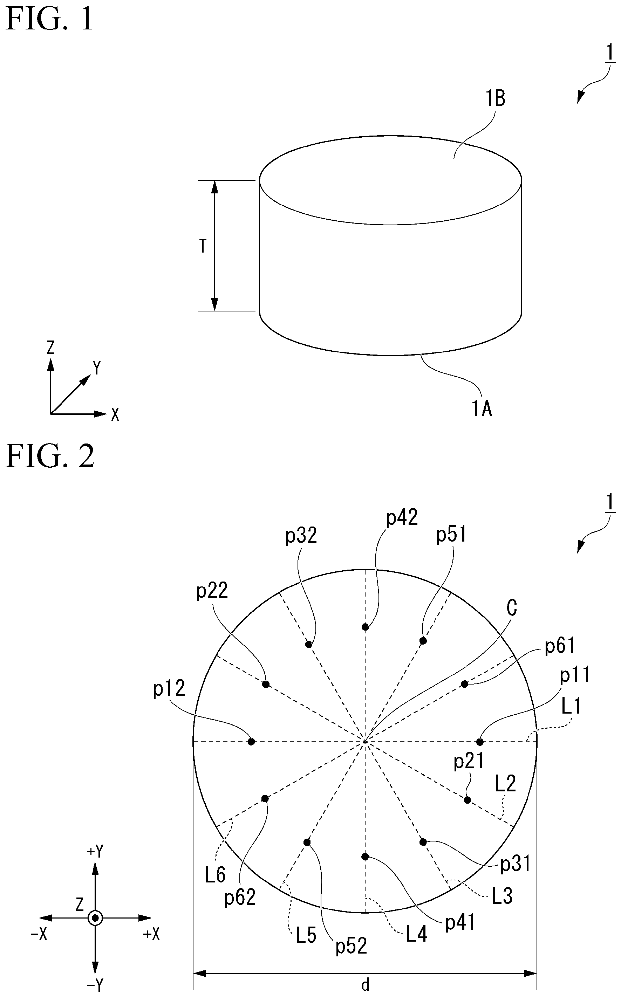

FIG. 1 is a cross-sectional view of a SiC single crystal 1 according to an embodiment. The SiC single crystal 1 is constituted by, for example, an n type SiC. A polytype of the SiC single crystal 1 is not particularly limited and may be any of 2H, 3C, 4H, and 6H. The SiC single crystal 1 is, for example, 4H-SiC.

The SiC single crystal 1 has a Si surface 1A, and a C surface 1B. The Si surface 1A and the C surface 1B are both end surfaces of the SiC single crystal 1 in the Z direction. The SiC single crystal 1 grows on a SiC seed crystal. During crystal growth, the Si surface 1A is disposed on the side of the SiC seed crystal, and the C surface 1B often becomes the crystal growth surface. The Si surface is a (0001) plane, or a surface inclined by an offset angle from the (0001) plane. The C surface is a (000-1) plane, or a surface inclined by an offset angle from the (000-1) plane. That is, the main surface (the Si surface or the C surface) may have or may not have the offset angle with respect to the (0001) plane or the (000-1) plane.

The offset angle is an angle formed between the surface perpendicular to the Z direction, which is the thickness direction of the SiC single crystal 1, and a (0004) plane. A crystal growth surface of the SiC single crystal 1 may have a portion having an offset angle with respect to the (0004) plane in a <11-20> direction. When the crystal growth surface has the offset angle with respect to the (0004) plane, it is possible to suppress occurrence of polytypes. The offset angle is, for example, greater than 0° and 10° or less, preferably 0.1° or more and 8° or less, more preferably 3.5° or more and 4.5° or less, and further preferably 4°.

The surface perpendicular to the Z direction of the SiC single crystal 1 may not have the offset angle with respect to the (0004) plane. In some cases, the SiC single crystal 1 is grown (just face growth) using the SiC seed crystal with no offset angle with respect to the (0004) plane ({0001} plane).

A crystal length T of the SiC single crystal 1 in the Z direction is, for example, 10 mm or more, preferably 20 mm or more, more preferably 30 mm or more, further preferably 40 mm or more, and particularly preferably 50 mm or more. The crystal length T of the SiC single crystal 1 in the Z direction is preferably, for example, 300 mm or less. The crystal length T of the SiC single crystal 1 in the Z direction is a maximum length between the Si surface 1A and the C surface 1B in the Z direction. As the crystal length T in the Z direction of the SiC single crystal 1 is increased, a large number of the SiC substrates can be acquired. In addition, when the SiC single crystal 1 is cooled from a high temperature environment during crystal growth as the crystal length T of the SiC single crystal 1 in the Z direction is increased, it is possible to suppress the lattice surface from flattening and maintain the curve of the lattice surface.

FIG. 2 is a plan view when the SiC single crystal 1 according to the embodiment is seen in a plan view in the Z direction. A plan view shape of the SiC single crystal 1 is a substantially circular shape.

A diameter d of the SiC single crystal 1 is, for example, 145 mm or more, and preferably 149 mm or more. In addition, the diameter d of the SiC single crystal 1 is preferably 155 mm or less, and more preferably 151 mm or less. In addition, the diameter d of the SiC single crystal 1 may be, for example, 195 mm or more, and preferably 199 mm or more. In addition, the diameter d of the SiC single crystal 1 may be, preferably 205 mm or less, and more preferably 201 mm or less. The diameter d of the SiC single crystal 1 may be 295 mm or more, and preferably 299 mm or more. The diameter d of the SiC single crystal 1 may be 305 mm or less, and preferably 301 mm or less. Here, the diameter d of the SiC single crystal 1 is a minimum diameter of the SiC single crystal 1, which corresponds to a minimum value of diameters of the SiC substrates that can be acquired. For example, when the SiC single crystal 1 has a diameter increased from the Si surface toward the C surface, the diameter of the Si surface corresponds to the diameter d of the SiC single crystal.

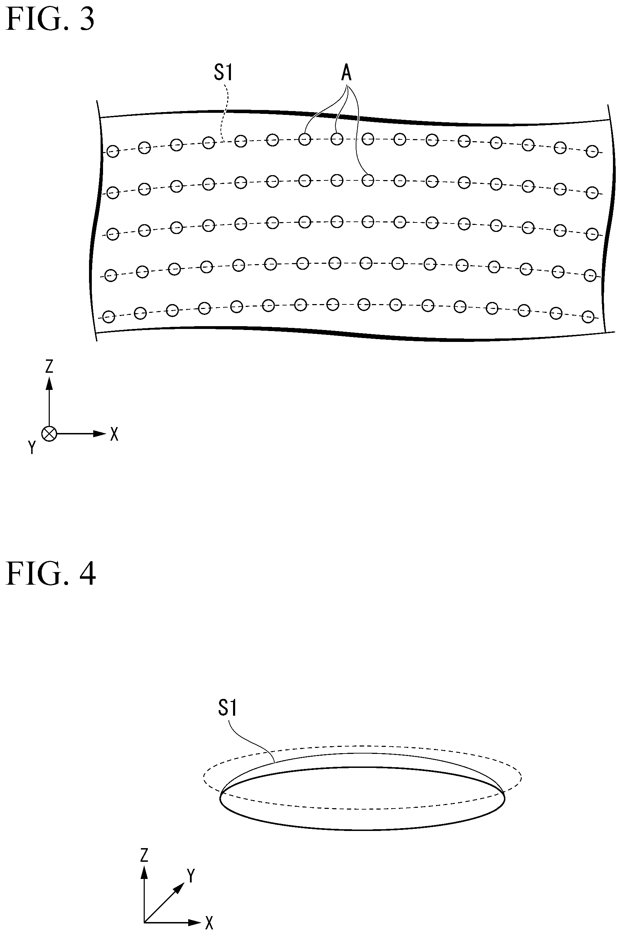

The SiC single crystal 1 is compound of Si and C, and has equivalent atomic planes arranged at equal intervals. The atomic plane is referred to as a lattice surface. For example, FIG. 3 is a cross-sectional view of characteristic parts of the SiC single crystal 1 according to the embodiment. FIG. 3 is a cross-sectional view of the SiC single crystal 1 cut along a straight line extending in a <11-20> direction (a first straight line L1 in FIG. 2). A lattice surface S1 is formed by atoms A that constitute the SiC single crystal 1. The lattice surface S1 of the SiC single crystal 1 shown in FIG. 3 has a convex shape curved toward the C surface 1B.

A shape of the lattice surface S1 can be measured through X-ray diffraction (XRD). A lattice surface to be measured is determined according to a direction in which the measurement is performed. When the measurement direction is [hkil], the measurement plane needs to satisfy a relationship (mh mk mi n). Here, m is an integer of 0 or more, and n is a natural number. For example, when the lattice surface is measured in a [11-20] direction, a (0004) plane is selected for m = 0 and n = 4, and a (22-416) plane is selected for m = 2 and n = 16. Meanwhile, when the lattice surface is measured in the [1-100] direction, the (0004) plane is selected for m = 0 and n = 4, and a (3-3016) plane is selected for m = 3 and n = 16. That is, the measurement plane may be different depending on the measurement direction. By satisfying the above-mentioned relationship, it is possible to prevent the lattice curve in the a plane or m plane direction, which has little effect on crystal growth, from being mistaken for the lattice curve in the c plane direction.

The lattice surface S1 measured along each of the first straight line L1, a second straight line L2, a third straight line L3, a fourth straight line L4, a fifth straight line L5 and a sixth straight line L6, shown in FIG. 2, is curved in a convex shape. In the lattice surface S1 measured along each of the first straight line L1, the second straight line L2, the third straight line L3, the fourth straight line L4, the fifth straight line L5 and the sixth straight line L6, a center C is located on the side of the C surface 1B of the end portion of the lattice surface S1 measured along each straight line. That is, the lattice surface S1, measured along each straight line, is curved so that its center is convex toward the C surface.

The measurement of X-ray diffraction is performed along each of the first straight line L1, the second straight line L2, the third straight line L3, the fourth straight line L4, the fifth straight line L5 and the sixth straight line L6. When the crystal length T of the SiC single crystal 1 of the measurement target is 500 μm or less, in order to eliminate the effect of warping of the SiC single crystal 1, it is preferable to vacuum-suck the SiC single crystal 1 onto the measurement stage. The first straight line L1 is a straight line passing through the center C when seen in a plan view in the Z direction. When the SiC single crystal 1 has an offset angle, the first straight line L1 is a straight line extending in the <11-20> direction. The second straight line L2 passes through the center C and is a straight line inclined 30° from the first straight line based on the center C. The third straight line L3 passes through the center C and is a straight line inclined 60° from the first straight line based on the center C. The second straight line L2 passes through the center C and is a straight line inclined 90° from the first straight line based on the center C. The second straight line L2 passes through the center C and is a straight line inclined 120° from the first straight line based on the center C. The second straight line L2 passes through the center C and is a straight line inclined 150° from the first straight line based on the center C. In FIG. 2, clockwise is considered a positive rotation direction.

The X-ray diffraction is measured at three points on each straight line: the center, the first measurement point, and the second measurement point. On the first straight line L1, X-ray diffraction measurements are performed at the center C, a first measurement point p11, and a second measurement point p12. On the second straight line L2, X-ray diffraction measurements are performed at the center C, a first measurement point p21, and a second measurement point p22. On the third straight line L3, X-ray diffraction measurements are performed at the center C, a first measurement point p31, and a second measurement point p32. On the fourth straight line L4, X-ray diffraction measurements are performed at the center C, a first measurement point p41, and a second measurement point p42. On the fifth straight line L5, X-ray diffraction measurements are performed at the center C, a first measurement point p51, and a second measurement point p52. On the sixth straight line L6, X-ray diffraction measurements are performed at the center C, a first measurement point p61, and a second measurement point p62.

Each of the first measurement point and the second measurement point is a point separated by d/3 from the center C. For example, when the SiC single crystal 1 undergoes offset growth, the point in the +X direction is the first measurement point, and the point in the -X direction is the second measurement point. However, since the fourth straight line L4 is perpendicular to the offset direction, a point separated by d/3 from the center C in the -Y direction is the first measurement point p41, and a point separated by d/3 from the center C in the +Y direction is the second measurement point p42. If the SiC single crystal 1 does not have offset growth, the +X direction and the -X direction are equivalent, and the +Y direction and the -Y direction are equivalent. Accordingly, if the SiC single crystal 1 does not have offset growth, the first and second measurement points are not distinguished.

When the lattice surface S1 is curved, since the diffraction direction of the X-ray changes, the positions of the peak angles ($\omega$ angles) of the diffraction peaks of the X-ray diffraction images obtained at the center, the first measurement point, and the second measurement point also change. The curve direction of the lattice surface S1 along each straight line can be confirmed from the change in the position of the peak angle of the diffraction peak.

FIG. 4 is a perspective view of an example of the lattice surface S1 of the SiC single crystal 1 according to the embodiment. The lattice surface S1 shown in FIG. 4 has a mountain-like shape. The lattice surface S1 shown in FIG. 4 has a convex shape curved with its center toward the C surface 1B from the outer circumferential portion. The center of the lattice surface S1 is located closer to the C surface 1B than the outer circumferential portion. The lattice surface S1 curves in a direction such that its center moves away from the Si surface 1A. The lattice surface S1 curves in a convex shape toward the C surface, regardless of the direction of the XY plane when cut. That is, in the example shown in FIG. 4, the lattice surface S1 measured along each of the first straight line L1, the second straight line L2, the third straight line L3, the fourth straight line L4, the fifth straight line L5 and the sixth straight line L6 all curve in a convex shape, satisfying the condition for the SiC single crystal 1 of the embodiment.

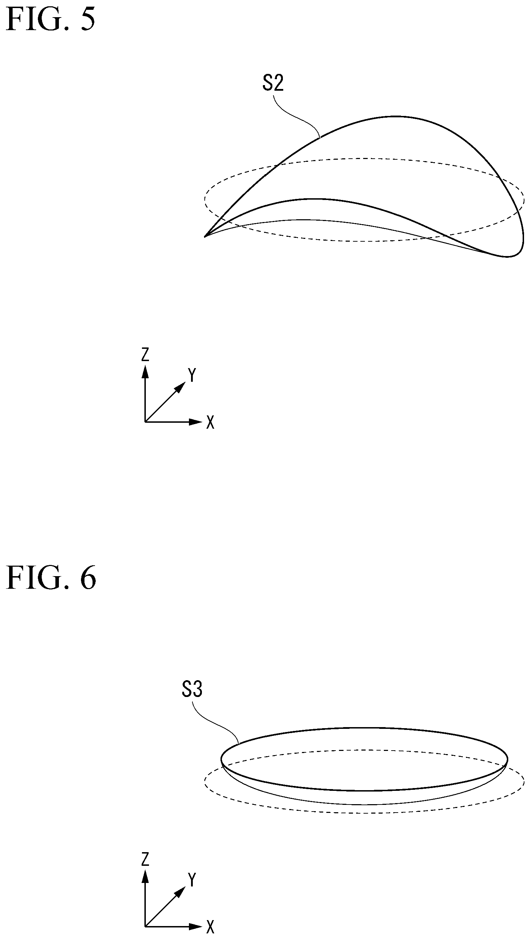

On the other hand, FIG. 5 is a perspective view of a lattice surface S2 of a SiC single crystal according to a first comparative example. The lattice surface S2 shown in FIG. 5 has a potato chip type (saddle type) shape. The lattice surface S2 shown in FIG. 5 has a convex shape with its center curved toward the C surface 1B in the X direction, but has a concave shape with its center curved away from the C surface 1B in the Y direction. For this reason, when the lattice surface S2 is cut on the XZ plane, it curves into a convex shape toward the C surface, but when cut on the YZ plane, it does not curve into a convex shape toward the C surface.

In addition, FIG. 6 is a perspective view of a lattice surface S3 of a SiC single crystal according to a second comparative example. The lattice surface S3 shown in FIG. 6 has a bowl-shaped configuration. The lattice surface S3 shown in FIG. 6 is a concave shape with its center curved away from the C surface 1B from the outer circumferential portion. The center of the lattice surface S1 is located closer to the Si surface 1A than the outer circumferential portion. The lattice surface S1 curves in a direction such that its center moves away from the C surface 1B. The lattice surface S3 curves into a concave shape in the direction away from the C surface, regardless of the direction of cutting in the XY plane.

In the SiC single crystal 1 according to the embodiment, the X-ray diffraction results measured at each of the first straight line L1, the second straight line L2, the third straight line L3, the fourth straight line L4, the fifth straight line L5 and the sixth straight line L6 preferably satisfy $(\omega_1-\omega_0)/(d/3) < -2.00 \times 10^{-6}$, more preferably satisfy $(\omega_1-\omega_0)/(d/3) < -3.00 \times 10^{-6}$, and even more preferably satisfy $(\omega_1-\omega_0)/(d/3) < -4.00 \times 10^{-6}$. Here, d is a diameter when the SiC single crystal 1 is seen in a plane view in the Z direction. $\omega_0$ is a maximum diffraction peak angle of the (0004) plane at the center C. $\omega_1$ is a maximum diffraction peak angle of the (0004) plane at the first measurement point. As this value is increased, the lattice surface S1 is largely curved. As this value is increased, the basal plane dislocation density on the C surface 1B with respect to the basal plane dislocation density on the Si surface 1A is reduced. The X-ray diffraction results measured at each of the first straight line L1, the second straight line L2, the third straight line L3, the fourth straight line L4, the fifth straight line L5 and the sixth straight line L6 may satisfy, for example, $(\omega_1-\omega_0)/(d/3) > -1.00\times10^{-5}$.

In addition, in the SiC single crystal 1 according to the embodiment, the X-ray diffraction results measured at each of the first straight line L1, the second straight line L2, the third straight line L3, the fourth straight line L4, the fifth straight line L5 and the sixth straight line L6 preferably satisfy $(\omega_2-\omega_0)/(d/3) < -2.00\times10^{-6}$, more preferably satisfy $(\omega_2-\omega_0)/(d/3) < -3.00\times10^{-6}$, and even more preferably satisfy $(\omega_2-\omega_0)/(d/3) < -4.00\times10^{-6}$. $\omega_2$ is a maximum diffraction peak angle of the (0004) plane at the second measurement point. As the value is increased, the lattice surface S1 is largely curved. As the value is increased, the basal plane dislocation density on the C surface 1B with respect to the basal plane dislocation density on the Si surface 1A is reduced. The X-ray diffraction results measured at each of the first straight line L1, the second straight line L2, the third straight line L3, the fourth straight line L4, the fifth straight line L5 and the sixth straight line L6 may satisfy $(\omega_2-\omega_0)/(d/3) > -1.00\times10^{-5}$.

In the X-ray diffraction results measured at each of the first straight line L1, the second straight line L2, the third straight line L3, the fourth straight line L4, the fifth straight line L5 and the sixth straight line L6, a half width of the maximum diffraction peaks in the (0004) plane at the first measurement point and the second measurement point preferably satisfies less than $5.20\times10^{-2}$, more preferably less than $4.80\times10^{-2}$, further preferably less than $4.40\times10^{-2}$, and particularly preferably less than $4.00\times10^{-2}$. A half width of the maximum diffraction peak in the X-ray diffraction expresses crystallinity of the SiC single crystal 1. As the half width of the maximum diffraction peak is reduced, crystallinity of the SiC single crystal 1 is increased. A half width of the maximum diffraction peaks of the (0004) plane at the first measurement point and the second measurement point may be, for example, $2.00\times10^{-2}$ or more.

The SiC single crystal 1 according to the embodiment preferably satisfies $(BPD_0-BPD_1)/BPD_0 > 64\%$, more preferably satisfies $(BPD_0-BPD_1)/BPD_0 > 70\%$, more preferably satisfies $(BPD_0-BPD_1)/BPD_0 > 80\%$, and more preferably satisfies $(BPD_0-BPD_1)/BPD_0 > 90\%$, more preferably satisfies $(BPD_0-BPD_1)/BPD_0 > 95\%$, and further more preferably satisfies $(BPD_0-BPD_1)/BPD_0 > 99\%$. $BPD_0$ is a basal plane dislocation density (pieces/cm$^2$) on the Si surface 1A, and $BPD_1$ is a basal plane dislocation density (pieces/cm$^2$) on the C surface. The SiC single crystal 1 grows with the Si surface 1A as the seed crystal side and the C surface 1B as the crystal growth surface. For this reason, this value expresses a decrease rate of the basal plane dislocation in the crystal growth of the SiC single crystal 1. As the decrease rate of the basal plane dislocation in the SiC single crystal 1 is increased, quality of the SiC substrate cut out from the vicinity of the C surface 1B is improved. The SiC single crystal 1 according to the embodiment may satisfy $(BPD_0-BPD_1)/BPD_0 < 100\%$.

In addition, the SiC single crystal 1 according to the embodiment preferably satisfies $(TSD_0-TSD_1)/TSD_0 > 48.2\%$, the SiC single crystal 1 more preferably satisfies $(TSD_0-TSD_1)/TSD_0 > 50\%$, the SiC single crystal 1 more preferably satisfies $(TSD_0-TSD_1)/TSD_0 > 60\%$, the SiC single crystal 1 more preferably satisfies $(TSD_0-TSD_1)/TSD_0 > 70\%$, the SiC single crystal 1 more preferably satisfies $(TSD_0-TSD_1)/TSD_0 > 80\%$, the SiC single crystal 1 more preferably satisfies $(TSD_0-TSD_1)/TSD_0 > 90\%$, the SiC single crystal 1 more preferably satisfies $(TSD_0-TSD_1)/TSD_0 > 95\%$, and the SiC single crystal 1 more preferably satisfies $(TSD_0-TSD_1)/TSD_0 > 99\%$. $TSD_0$ is a threading screw dislocation density (pieces/cm$^2$) on the Si surface 1A, and $TSD_1$ is a threading screw dislocation density (pieces/cm$^2$) on the C surface. This value expresses a decrease rate of the threading screw dislocation in the crystal growth of the SiC single crystal 1. As the decrease rate of the threading screw dislocation in the SiC single crystal 1 is increased, quality of the SiC substrate cut out from the vicinity of the C surface 1B is improved. The SiC single crystal 1 according to the embodiment may satisfy $(TSD_0-TSD_1)/TSD_0 < 100\%$.

In addition, the SiC single crystal 1 according to the embodiment satisfies $(BPD_0-BPD_1)/(BPD_0\times T) > 1\%/mm$, and preferably satisfies $(TSD_0-TSD_1)/(TSD_0\times T) > 1\%/mm$. In addition, the SiC single crystal 1 according to the embodiment satisfies $(BPD_0-BPD_1)/(BPD_0\times T) > 2\%/mm$, and more preferably satisfies $(TSD_0-TSD_1)/(TSD_0\times T) > 2\%/mm$. In addition, the SiC single crystal 1 according to the embodiment satisfies $(BPD_0-BPD_1)/(BPD_0\times T) > 3\%/mm$, and more preferably satisfies $(TSD_0-TSD_1)/(TSD_0\times T) > 3\%/mm$. T is a crystal length of the SiC single crystal 1. $(BPD_0-BPD_1)/(BPD_0\times T)$ expresses a decrease rate of the basal plane dislocation per unit length in the Z direction. $(TSD_0-TSD_1)/(TSD_0\times T)$ expresses a decrease rate of the threading screw dislocation per unit length in the Z direction. In addition, the SiC single crystal 1 according to the embodiment may satisfy $(BPD_0-BPD_1)/(BPD_0\times T) < 5\%/mm$, and may satisfy $(TSD_0-TSD_1)/(TSD_0\times T) < 10\%/mm$.

For example, the basal plane dislocation density $(BPD_1)$ on the C surface 1B of the SiC single crystal 1 may be less than 500 pieces/cm$^2$. The basal plane dislocation density $(BPD_1)$ on the C surface 1B may be, for example, less than 400 pieces/cm$^2$, less than 300 pieces/cm$^2$, less than 200 pieces/cm$^2$, less than 100 pieces/cm$^2$, or less than 50 pieces/cm$^2$. The lower the basal plane dislocation density on the C surface, the higher quality SiC substrate can be obtained.

For example, the threading screw dislocation density $(TSD_1)$ on the C surface 1B of the SiC single crystal 1 may be less than 300 pieces/cm$^2$. The threading screw dislocation density $(TSD_1)$ on the C surface 1B may be, for example, less than 200 pieces/cm$^2$, less than 172 pieces/cm$^2$, less than 150 pieces/cm$^2$, less than 100 pieces/cm$^2$, or less than 50 pieces/cm$^2$. The lower the threading screw dislocation density on the C surface, the higher quality SiC substrate can be obtained.

For example, the etch pit density (EPD) on the C surface 1B of the SiC single crystal 1 may be less than 4000 pieces/cm$^2$. The etch pit density (EPD) on the C surface 1B may be, for example, less than 3000 pieces/cm$^2$, less than 2000 pieces/cm$^2$, less than 1300 pieces/cm$^2$, less than 1000 pieces/cm$^2$, or less than 500 pieces/cm$^2$. The lower the etch pit density on the C surface, the higher quality SiC substrate can be obtained.

The basal plane dislocation density, the threading screw dislocation density, and etch pit density on C surface 1B of the SiC single crystal 1 may be measured by irradiating X-rays on C surface 1B and performing reflection X-ray topography analysis. Before the measurement, the C surface 1B may be polished.

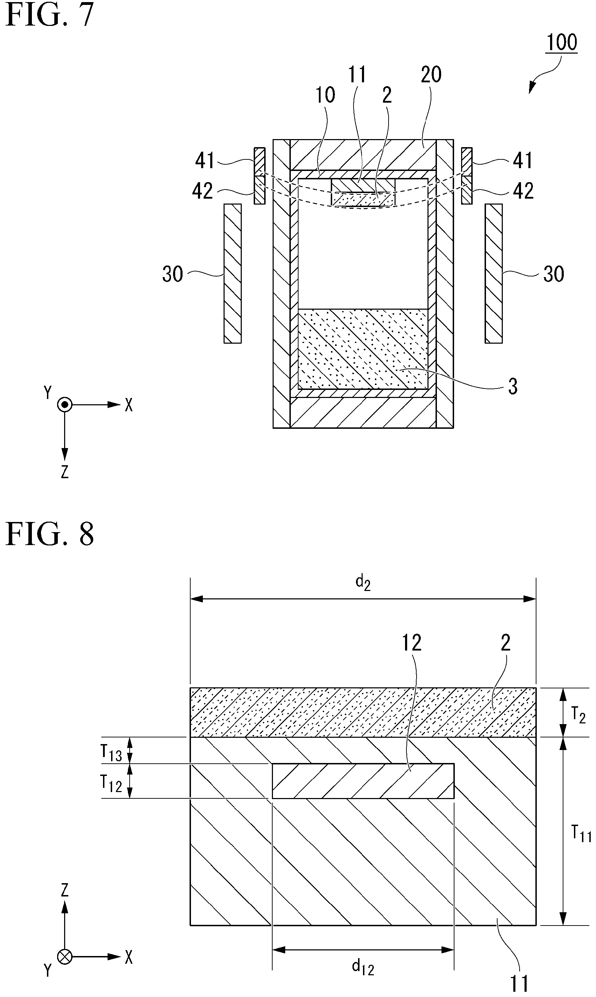

Next, a method of manufacturing the SiC single crystal 1 according to the embodiment will be described. FIG. 7 to FIG. 9 are views for describing the method of manufacturing the SiC single crystal 1 according to the embodiment.

A manufacturing apparatus 100 includes, for example, a crucible 10, a holding member 11, an insulating material 20, a heating member 30, and shielding members 41 and 42. FIG. 7 shows a state of the SiC single crystal 1 before the crystal growth begins.

The crucible 10 is formed of, for example, graphite. The crucible 10 surrounds a growth space. A SiC seed crystal 2 and a SiC raw material 3 are disposed in a growth space of the crucible 10. A gas sublimated from the SiC raw material 3 recrystallizes on the surface of the SiC seed crystal 2, resulting in the crystal growth of the SiC single crystal 1.

The holding member 11 holds the SiC seed crystal 2. The holding member 11 may be integrated with the crucible 10. A thermal expansion coefficient of the holding member 11 is within $\pm 10\%$ with respect to a thermal expansion coefficient of the SiC seed crystal 2. The holding member 11 is formed of, for example, graphite. The SiC seed crystal 2 is adhered to the holding member 11 using a carbon adhesive agent or the like.

FIG. 8 is an enlarged cross-sectional view of the vicinity of the holding member 11. A thickness $T_{11}$ of the holding member 11 is, for example, 200% or more and 800% or less of the thickness $T_2$ of the SiC seed crystal 2. A thickness $T_2$ of the SiC seed crystal 2 is, for example, 0.3 mm or more and less than 7 mm.

An expansion section 12 is provided in the holding member 11. The expansion section 12 has a higher expansion rate than the graphite that constitutes the holding member 11 under the high temperature environment in which SiC crystals grow. The expansion section 12 contains a high melting point metal or high melting point metal compound. The expansion section 12 contains, for example, SiC, Ta, TaC, Nb, NbC, or the like. A thickness $T_{12}$ of the expansion section 12 is, for example, 50% or more and 100% or less of the thickness $T_2$ of the SiC seed crystal 2. A diameter $d_{12}$ of the expansion section 12 is, for example, 30% or more and 70% or less of a diameter $d_2$ of the SiC seed crystal 2. The expansion section 12 is positioned at a distance from the adhesive surface with the SiC seed crystal 2 that is 10% or more and 70% or less of the thickness $T_2$ of the SiC seed crystal 2. That is, a thickness $T_{13}$ of the holding member 11 between the expansion section 12 and the SiC seed crystal 2 is, for example, 10% or more and 70% or less of the thickness $T_2$ of the SiC seed crystal 2.

The sizes of the holding member 11 and the expansion section 12 affect the curve state of the lattice surface S1. For example, when the thickness $T_{11}$ of the holding member 11 is set to 200% or more and 300% or less of the thickness $T_2$ of the SiC seed crystal 2, the thickness $T_{12}$ of the expansion section 12 is set to 50% or more and 70% or less of the thickness $T_2$ of the SiC seed crystal 2, a thickness $T_{13}$ of the holding member 11 between the expansion section 12 and the SiC seed crystal 2 is set to 50% or more and 70% or less of the thickness $T_2$ of the SiC seed crystal 2, and they satisfy the following film-forming condition, the lattice surface S1 satisfies $(\omega_1-\omega_0)/(d/3) < -2.00 \times 10^{-6}$.

In addition, for example, when the thickness $T_{11}$ of the holding member 11 is set to greater than 300% and 500% or less of the thickness $T_2$ of the SiC seed crystal 2, the thickness $T_{12}$ of the expansion section 12 is set to greater than 70% and 85% or less of the thickness $T_2$ of the SiC seed crystal 2, the thickness $T_{13}$ of the holding member 11 between the expansion section 12 and the SiC seed crystal 2 is set to 30% or more and less than 50% of the thickness $T_2$ of the SiC seed crystal 2, and they satisfy the following film-forming condition, the lattice surface S1 satisfies $(\omega_1-\omega_0)/(d/3) < -3.00 \times 10^{-6}$.

In addition, for example, when the thickness $T_{11}$ of the holding member 11 is set to greater than 500% and 800% or less of the thickness $T_2$ of the SiC seed crystal 2, the thickness $T_{12}$ of the expansion section 12 is set to greater than 85% and 100% or less of the thickness $T_2$ of the SiC seed crystal 2, the thickness $T_{13}$ of the holding member 11 between the expansion section 12 and the SiC seed crystal 2 is set to 10% or more and less than 30% of the thickness $T_2$ of the SiC seed crystal 2, and they satisfy the following film-forming condition, the lattice surface S1 satisfies $(\omega_1-\omega_0)/(d/3) < -4.00 \times 10^{-6}$.

The insulating material 20 covers a periphery of the crucible 10. The insulating material 20 is, for example, graphite felt and a molded insulating material made by solidifying and molding the graphite felt.

The heating member 30 surrounds an outer circumference of the crucible 10. The heating member 30 heats the SiC raw material 3. The heating member 30 is, for example, a heating coil.

The shielding members 41 and 42 are disposed between the crucible 10 and the heating member 30 when seen in the Z direction. A width of the shielding members 41 and 42 in the radial direction is, for example, 2% or more and 30% or less of a width of the heating member 30 in the radial direction. The shielding members 41 and 42 contain, for example, copper.

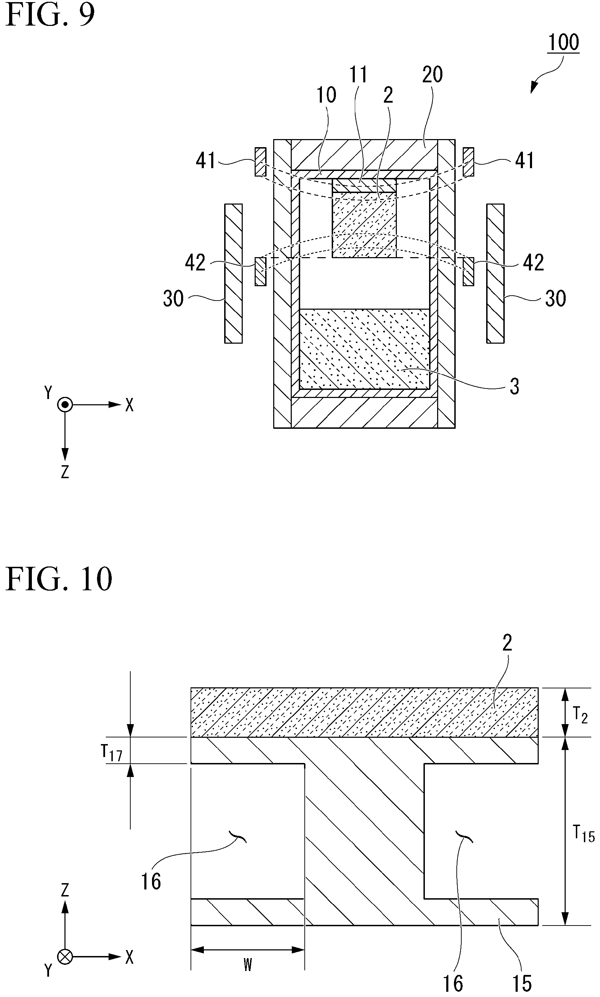

FIG. 9 shows a state of the SiC single crystal 1 during crystal growth. The shielding member 42 can change its position in the Z direction to match the crystal growth of the SiC single crystal 1. By changing the positions of the shielding members 41 and 42, it is possible to change the temperature distribution in the growth space in the crucible 10.

When the SiC single crystal 1 is grown using the manufacturing apparatus 100, the temperature of the SiC raw material 3 is set to 2100°C or more and 2400°C or less, and the temperature of the SiC seed crystal 2 is heated to 2000°C or more and 2300°C or less. By heating the growth space, the SiC raw material 3 sublimes. At this time, the expansion section 12 expands from the holding member 11. As the expansion section 12 expands, during crystal growth, the SiC seed crystal 2 curves convexly with its center protruding toward the SiC raw material 3. By making the center of the SiC seed crystal 2 convexly curve toward the SiC raw material 3, the curve direction of the lattice surface of the SiC single crystal 1 can be controlled.

In addition, the temperature distribution within the growth space is controlled during crystal growth of the SiC single crystal 1 and during cooling of the growth space.

First, during the crystal growth of the SiC single crystal 1, the temperature distribution in the vicinity of the SiC seed crystal 2 (a boundary between the SiC seed crystal 2 and the SiC single crystal 1) satisfy the following first condition.

$$\text{First condition: } 0°C/mm < (T1-T0)/d < 5.00°C/mm$$

T1 is a temperature on the outer circumferential portion of the SiC seed crystal 2, and T0 is a temperature on the central portion of the SiC seed crystal 2. Here, d is a diameter of the SiC single crystal 1. The above-mentioned condition can be achieved by making the height position of the lower end of the shielding member 41 the same of the upper end of the holding member 11. By controlling the temperature distribution in the vicinity of the SiC seed crystal 2, the curve direction of the SiC single crystal 1 can be controlled.

In addition, during the latter half of the crystal growth and cooling period of the SiC single crystal 1, the temperature distribution in the vicinity of the crystal growth surface of the SiC single crystal 1 satisfies the following second condition, and the temperature distribution at the central height position in the thickness direction of the holding member 11 satisfies the following third condition.

$$\text{Second condition: } -5.00°C/mm < (T1'-T0')/d < -0.01°C/mm$$

$$\text{Third condition: } -5.00°C/mm < (T1''-T0'')/d_2 < -0.01°C/mm$$

T1' is a temperature on the outer circumferential portion of the SiC single crystal 1, and T0' is a temperature on the central portion of the SiC single crystal 1. T1" is a temperature on the outer circumferential portion of the holding member 11, and T0" is a temperature on the central portion of the holding member 11. Here, $d_2$ is a diameter of the holding member 11. The latter half of the crystal growth is the time from the end of the growth time to the time when the temperature of the SiC raw material 3 exceeds 2100°C, in the range of 2% or more and 10% or less of the growth time. The cooling period is the time until the temperature of the SiC seed crystal 2 drops below 1000°C. The above-mentioned condition can be achieved by matching the height position of the upper end of the shielding member 42 with the height position of the crystal growth surface of the SiC single crystal 1 where the crystal is growing.

In the latter half of the crystal growth and the cooling period of the SiC single crystal 1, by making the isothermal surface near the SiC seed crystal 2 into a convex shape with the center protruding toward the SiC raw material 3, and making the isothermal surface near the crystal growth surface of the SiC single crystal 1 into a concave shape with the center moving away from the SiC raw material, the lattice surface of the SiC single crystal 1 can be made to have a convex shape toward the C surface 1B.

The SiC single crystal 1 is allowed to grow until it has a thickness at least three times the thickness $T_{11}$ of the holding member 11. By making the thickness of the SiC single crystal 1 sufficient, it is possible to prevent the lattice surface curve from disappearing when the growth space cools and the expansion section 12 returns to its original shape.

As described above, the expansion section 12 is provided within the holding member 11, the temperature distribution within the growth space during crystal growth and cooling of the SiC single crystal 1 is controlled, and the crystal growth amount of the SiC single crystal 1 is specified, thereby making it possible to produce the SiC single crystal 1 of the embodiment. That is, while controlling the shape of the crystal growth surface of the SiC single crystal in the crystal growth initial stage, the stress generated inside the SiC single crystal 1 is controlled by providing the expansion section 12 within the holding member 11, thereby controlling the warp (shape) of the lattice surface, and the SiC single crystal 1 according to the embodiment is obtained.

In addition, a holding member 15 shown in FIG. 10 may be used instead of the holding member 11 described above. The holding member 15 shown in FIG. 10 has a concave portion 16. The concave portion 16 is a position overlapping the SiC seed crystal 2 when seen in the Z direction. The concave portion 16 is formed only in the direction where the curvature of the lattice surface of the SiC seed crystal 2 is measured using the X-ray diffraction and the curvature is $r \geq -8.00 \times 10^2$. Here, the curvature is considered positive if the curve is concave toward the C surface direction (the center is located in the -Z direction from the end portion).

A thickness $T_{17}$ of the graphite member between the SiC seed crystal 2 and the concave portion 16 is 10% or more and 70% or less of the thickness $T_2$ of the SiC seed crystal 2. A thickness $T_{15}$ of the holding member 15 in the Z direction is 200% or more and 800% or less of the thickness $T_2$ of the SiC seed crystal 2. A width W of the concave portion 16 in the radial direction is 1% or more and 20% or less of the diameter of the holding member 15.

For example, when the thickness $T_{15}$ of the holding member 15 in the Z direction is set to 200% or more and 300% or less of the thickness $T_2$ of the SiC seed crystal 2, the width W of the concave portion 16 in the radial direction is set to 1% or more and 5% or less of the diameter of the holding member 15, the thickness $T_{17}$ of the graphite member between the SiC seed crystal 2 and the concave portion 16 is set to 50% or more and 70% or less of the thickness $T_2$ of the SiC seed crystal 2, and they satisfy the above-mentioned film-forming condition, the lattice surface S1 satisfies $(\omega_1-\omega_0)/(d/3) < -2.00 \times 10^{-6}$.

For example, when the thickness $T_{15}$ of the holding member 15 in the Z direction is set to greater than 300% and 500% or less of the thickness $T_2$ of the SiC seed crystal 2, the width W of the concave portion 16 in the radial direction is set to greater than 5% and 10% or less of the diameter of the holding member 15, the thickness $T_{17}$ of the graphite member between the SiC seed crystal 2 and the concave portion 16 is set to 30% or more and less than 50% of the thickness $T_2$ of the SiC seed crystal 2, and they satisfy the above-mentioned film-forming condition, the lattice surface S1 satisfies $(\omega_1-\omega_0)/(d/3) < -3.00 \times 10^{-6}$.

For example, when the thickness $T_{15}$ of the holding member 15 in the Z direction is set to greater than 500% and less than 800% of the thickness $T_2$ of the SiC seed crystal 2, the width W of the concave portion 16 in the radial direction is set to greater than 10% and 20% or less of the diameter of the holding member 15, the thickness $T_{17}$ of the graphite member between the SiC seed crystal 2 and the concave portion 16 is set to 10% or more and less than 30% of the thickness $T_2$ of the SiC seed crystal 2, and they satisfy the above-mentioned film-forming condition, the lattice surface S1 satisfies $(\omega_1-\omega_0)/(d/3) < -4.00 \times 10^{-6}$.

Even when the holding member 15 is used instead of the holding member 11, the central portion of holding member 15 expands more than the area where the concave portion 16 is formed, and the same effect is obtained as when the holding member 11 has the expansion section 12. That is, by controlling the shape of the crystal growth surface of the SiC single crystal in the crystal growth initial stage while controlling the stress generated inside the SiC single crystal 1 by the holding member 15, the warp (shape) of the lattice surface can be controlled, and the SiC single crystal 1 according to the embodiment can be obtained.

In addition, the fabricated SiC single crystal 1 is processed into a cylindrical shape and sliced to fabricate a SiC substrate.

In the SiC single crystal 1 of the embodiment, the lattice surface S1 has a convex shape toward the C surface, so that the basal plane dislocation density of the C surface 1B is smaller than the basal plane dislocation density of the Si surface 1A. That is, the SiC single crystal 1 in the embodiment has a high rate of decrease in basal plane dislocation density due to crystal growth. For this reason, the SiC single crystal 1 according to the embodiment has a low basal plane dislocation density near the C surface, and a high-quality SiC substrate can be obtained by cutting out the SiC substrate from near the C surface.

The SiC substrate of this embodiment is obtained by slicing the SiC single crystal 1 described above. The SiC substrate includes the SiC single crystal that satisfy the above conditions. The SiC substrate may consist of the SiC single crystal that satisfy the above conditions. Therefore, the lattice surface S1 of the SiC substrate measured along each of the first straight line L1, second straight line L2, third straight line L3, fourth straight line L4, fifth straight line L5, and sixth straight line L6, is curved in a convex shape. In the lattice surface S1 measured along each of the first straight line L1, second straight line L2, third straight line L3, fourth straight line L4, fifth straight line L5, and sixth straight line L6, the center C is located on the side of the C surface 1B of the end portion of the lattice surface S1 measured along each straight line. That is, the lattice surface S1, measured along each straight line, is curved so that its center is convex toward the C surface. Since the SiC substrate of this embodiment satisfies the above conditions, the in-plane distribution of dislocations is less biased. This SiC substrate increases the yield when fabricating SiC devices.

The thickness of the SiC substrate in the Z direction is thinner than the crystal length T in the Z direction of the SiC single crystal 1. The thickness of the SiC substrate in the Z direction may be, for example, less than 600 $\mu$m, less than 450 $\mu$m, less than 400 $\mu$m, less than 375 $\mu$m, less than 350 $\mu$m, less than 300 $\mu$m. The thickness of the SiC substrate in the Z direction may be more than 200 $\mu$m.

The SiC epitaxial layer may be stacked on one side of the SiC substrate of this embodiment. The SiC epitaxial wafer includes the SiC substrate and the SiC epitaxial layer formed on one surface of the SiC substrate. The SiC epitaxial layer may be formed on the Si surface of the SiC substrate or on the C surface.

Hereinabove, although the preferred embodiment of the present invention has been described in detail, the present invention is not limited to the specific embodiment, and various modifications and alterations are possible within the scope of the spirit of the present invention described in the claims.

[Examples]

(Example 1)

Seed crystals with a diameter of 6 inches (150 mm) were prepared. Then, using the manufacturing apparatus 100 shown in FIG. 7 to FIG. 9, the SiC single crystal 1 was grown to a thickness of 32.6 mm on the SiC seed crystal 2 having a thickness of 1.2 mm.

The holding member 11 used graphite. The thickness $T_{11}$ of the holding member 11 was 700% of the thickness $T_2$ of the SiC seed crystal 2. A material of the expansion section 12 was NbC. The thickness $T_{12}$ of the expansion section 12 was 90% of the thickness $T_2$ of the SiC seed crystal 2. The diameter $d_{12}$ of the expansion section 12 was 60% of the diameter $d_2$ of the SiC seed crystal 2. The thickness $T_{13}$ of the holding member 11 between the expansion section 12 and the SiC seed crystal 2 was 20% of the thickness $T_2$ of the SiC seed crystal 2.

During crystal growth of the SiC single crystal 1, the height position of the lower end of the shielding member 41 was set to the same height position as the upper end of the holding member 11, and the height position of the upper end of the shielding member 42 was set to the height position of the crystal growth surface of the SiC single crystal 1 for crystal growth. As a result, the temperature distribution within the growth space during the crystal growth and cooling period was set to satisfy the first condition, the second condition and the third condition. A movement speed of the shielding member 41 was 2.0 mm/h or less. When the movement speed is greater than 2.0 mm/h, sudden temperature changes can cause deterioration in crystallinity and half width.

The fabricated SiC single crystal 1 was taken out and the X-ray diffraction measurements were performed along the first straight line L1, the second straight line L2, the third straight line L3, the fourth straight line L4, the fifth straight line L5, and the sixth straight line L6. The X-ray diffraction was performed at each of the center, the first measurement point, and the second measurement point on each of the straight lines. Then, the diffraction peak angle of the maximum diffraction peak of the (0004) plane and the half width of the maximum diffraction peak of the (0004) plane at each measurement point were calculated. Using the measurement results of the first measurement point and the center, $(\omega_1-\omega_0)/(d/3)$ was calculated, and using the measurement results of the second measurement point and the center, $(\omega_2-\omega_0)/(d/3)$ was calculated. Both of these represent the amount of change in diffraction peak angle per unit length (deg/mm).

The X-ray diffraction results for Example 1 are summarized in Table 1 below. As shown in FIG. 4, it was confirmed that the amount of change in the diffraction peak angle per unit length was negative in all cases, and the shape of the lattice surface S1 of the SiC single crystal 1 in Example 1 was a mountain shape with the center protruding toward the C surface.

[Table 1]

| | | Amount of change of peak angle per unit length (deg/mm) | FWHM (deg/mm) |
|---|---|---|---|
| First straight line L1 | | $(\omega_1-\omega_0)/(d/3) = -5.03\times10^{-5}$ | $4.25\times10^{-2}$ |
| | | $(\omega_2-\omega_0)/(d/3) = -6.70\times10^{-5}$ | $4.18\times10^{-2}$ |
| Second straight line L2 | | $(\omega_1-\omega_0)/(d/3) = -6.86\times10^{-6}$ | $3.93\times10^{-2}$ |
| | | $(\omega_2-\omega_0)/(d/3) = -7.70\times10^{-5}$ | $3.95\times10^{-2}$ |
| Third straight line L3 | | $(\omega_1-\omega_0)/(d/3) = -4.94\times10^{-5}$ | $4.25\times10^{-2}$ |
| | | $(\omega_2-\omega_0)/(d/3) = -9.14\times10^{-5}$ | $4.12\times10^{-2}$ |
| Fourth straight line L4 | | $(\omega_1-\omega_0)/(d/3) = -2.65\times10^{-5}$ | $4.10\times10^{-2}$ |
| | | $(\omega_2-\omega_0)/(d/3) = -6.40\times10^{-5}$ | $3.93\times10^{-2}$ |
| Fifth straight line L5 | | $(\omega_1-\omega_0)/(d/3) = -7.98\times10^{-6}$ | $4.25\times10^{-2}$ |
| | | $(\omega_2-\omega_0)/(d/3) = -7.15\times10^{-5}$ | $4.25\times10^{-2}$ |
| Sixth straight line L6 | | $(\omega_1-\omega_0)/(d/3) = -7.98\times10^{-6}$ | $3.93\times10^{-2}$ |
| | | $(\omega_2-\omega_0)/(d/3) = -5.24\times10^{-5}$ | $3.99\times10^{-2}$ |

Next, in each of the Si surface 1A and the C surface 1B of the fabricated SiC single crystal 1, the etch pit density (EPD), the basal plane dislocation density (BPD), and the threading screw dislocation density (TSD) were measured. The results are shown in the following Table 2. The type and number of dislocations can be determined from the shapes of etch pits produced by molten KOH etching using an optical microscope, an electron microscope (SEM), etc.

[Table 2]

|  | EPD (pieces/cm$^2$) | BPD (pieces/cm$^2$) | TSD (pieces/cm$^2$) |
|---|---|---|---|
| C surface | 1300 | 50 | 172 |
| Si surface | 9500 | 1000 | 1061 |
| Decrease rate (%) | 86.3 | 95.0 | 83.8 |
| Decrease rate per single growth (%/mm) | 2.65 | 2.91 | 2.57 |

(Comparative Example 1)

Comparative Example 1 is distinguished from Example 1 in that the holding member formed of graphite only is used. The other conditions were the same as in Example 1, and the SiC single crystal was grown. In Comparative Example 1, the SiC single crystal was grown to 37.4 mm.

Even in Comparative Example 1, similar to Example 1, the X-ray diffraction measurement was measured along each of the first straight line L1, the second straight line L2, the third straight line L3, the fourth straight line L4, the fifth straight line L5, the sixth straight line L6. The X-ray diffraction results of Comparative Example 1 are summarized in the following Table 3. From the measurement results in Table 3, it was confirmed that the shape of the lattice surface S2 of the SiC single crystal in Comparative Example 1 was a potato chip type, as shown in FIG. 5.

[Table 3]

|  | Amount of change of peak angle per unit length (deg/mm) | FWHM (deg/mm) |
|---|---|---|
| First straight line L1 | $(\omega_1-\omega_0)/(d/3) = 1.03\times10^{-4}$ | $4.30\times10^{-2}$ |
|  | $(\omega_2-\omega_0)/(d/3) = 4.24\times10^{-6}$ | $4.41\times10^{-2}$ |
| Second straight line L2 | $(\omega_1-\omega_0)/(d/3) = 2.05\times10^{-4}$ | $4.10\times10^{-2}$ |
|  | $(\omega_2-\omega_0)/(d/3) = 7.23\times10^{-5}$ | $3.92\times10^{-2}$ |
| Third straight line L3 | $(\omega_1-\omega_0)/(d/3) = 1.23\times10^{-4}$ | $4.11\times10^{-2}$ |
|  | $(\omega_2-\omega_0)/(d/3) = 4.07\times10^{-5}$ | $4.14\times10^{-2}$ |
| Fourth straight line L4 | $(\omega_1-\omega_0)/(d/3) = -1.94\times10^{-5}$ | $4.30\times10^{-2}$ |
|  | $(\omega_2-\omega_0)/(d/3) = -1.00\times10^{-4}$ | $4.29\times10^{-2}$ |
| Fifth straight line L5 | $(\omega_1-\omega_0)/(d/3) = -1.68\times10^{-4}$ | $4.12\times10^{-2}$ |
|  | $(\omega_2-\omega_0)/(d/3) = -1.29\times10^{-4}$ | $4.19\times10^{-2}$ |
| Sixth straight line L6 | $(\omega_1-\omega_0)/(d/3) = -8.98\times10^{-5}$ | $3.88\times10^{-2}$ |
|  | $(\omega_2-\omega_0)/(d/3) = -6.95\times10^{-5}$ | $4.03\times10^{-2}$ |

In addition, even in the SiC single crystal of Comparative Example 1, the etch pit density (EPD), the basal plane dislocation density (BPD), and the threading screw dislocation density (TSD) were measured on each of the Si surface and C surface. The results are shown in the following Table 4.

[Table 4]

|  | EPD (pieces/cm$^2$) | BPD (pieces/cm$^2$) | TSD (pieces/cm$^2$) |
|---|---|---|---|
| C surface | 1100 | 580 | 315 |
| Si surface | 3600 | 1600 | 608 |
| Decrease rate (%) | 69.4 | 63.8 | 48.2 |
| Decrease rate per single growth (%/mm) | 1.86 | 1.71 | 1.29 |

(Comparative Example 2)

Comparative Example 2 is distinguished from Example 1 in that the holding member consisting of graphite only was used, and temperature control using a shielding member was not performed during crystal growth. The other conditions were the same as in Example 1, and the SiC single crystal was grown. In Comparative Example 2, the SiC single crystal was grown to 38.3 mm.

Even in Comparative Example 2, similar to Example 1, the X-ray diffraction measurement was performed along each of the first straight line L1, the second straight line L2, the third straight line L3, the fourth straight line L4, the fifth straight line L5, the sixth straight line L6. The X-ray diffraction results of Comparative Example 2 are summarized in the following Table 5. From the measurement results of Table 5, it was confirmed that the shape of the lattice surface S3 of the SiC single crystal in Comparative Example 2 is a bowl shape with the center protruding in the direction away from the C surface, as shown in FIG. 6.

[Table 5]

| | Amount of change of peak angle per unit length (deg/mm) | FWHM (deg/mm) |
|---|---|---|
| First straight line L1 | $(\omega_1-\omega_0)/(d/3) = 2.52\times10^{-4}$ | $4.49\times10^{-2}$ |
| | $(\omega_2-\omega_0)/(d/3) = 6.43\times10^{-4}$ | $4.78\times10^{-2}$ |
| Second straight line L2 | $(\omega_1-\omega_0)/(d/3) = 4.22\times10^{-4}$ | $4.37\times10^{-2}$ |
| | $(\omega_2-\omega_0)/(d/3) = 5.41\times10^{-4}$ | $3.26\times10^{-2}$ |
| Third straight line L3 | $(\omega_1-\omega_0)/(d/3) = 4.27\times10^{-4}$ | $4.48\times10^{-2}$ |
| | $(\omega_2-\omega_0)/(d/3) = 4.95\times10^{-4}$ | $4.44\times10^{-2}$ |
| Fourth straight line L4 | $(\omega_1-\omega_0)/(d/3) = 4.68\times10^{-4}$ | $4.02\times10^{-2}$ |
| | $(\omega_2-\omega_0)/(d/3) = 4.56\times10^{-4}$ | $4.26\times10^{-2}$ |
| Fifth straight line L5 | $(\omega_1-\omega_0)/(d/3) = 3.51\times10^{-4}$ | $4.56\times10^{-2}$ |
| | $(\omega_2-\omega_0)/(d/3) = 4.68\times10^{-4}$ | $4.44\times10^{-2}$ |
| Sixth straight line L6 | $(\omega_1-\omega_0)/(d/3) = 3.19\times10^{-4}$ | $4.18\times10^{-2}$ |
| | $(\omega_2-\omega_0)/(d/3) = 5.25\times10^{-4}$ | $4.32\times10^{-2}$ |

In addition, even in the SiC single crystal of Comparative Example 2, the etch pit density (EPD), the basal plane dislocation density (BPD), and the threading screw dislocation density (TSD) on each of the Si surface and the C surface was measured. The results are shown in the following Table 6.

[Table 6]

| | EPD (pieces/cm$^2$) | BPD (pieces/cm$^2$) | TSD (pieces/cm$^2$) |
|---|---|---|---|
| C surface | 4300 | 2900 | 464 |
| Si surface | 9200 | 6400 | 649 |
| Decrease rate (%) | 53.3 | 54.7 | 28.5 |
| Decrease rate per single growth (%/mm) | 1.39 | 1.43 | 0.74 |

The SiC single crystal in Example 1 had a lower basal plane dislocation density on the C surface compared to Comparative Example 1 and Comparative Example 2. In addition, the SiC single crystal in Example 1 had a greater decrease rate of the basal plane dislocation density during crystal growth compared to Comparative Example 1 and Comparative Example 2.

In each of Example 1, Comparative Example 1 and Comparative Example 2, the SiC single crystal were fabricated using the SiC seed crystal with a diameter of 6 inche (150 mm). A similar study was conducted using the SiC seed crystal with a diameter of 8 inche (200 mm). The same trend was observed in the case of 200 mm diameter as in the case of 150 mm diameter.

EXPLANATION OF REFERENCES

1 SiC single crystal
1A Si Surface
1B C Surface
2 SiC Seed crystal
3 SiC Raw material
10 Crucible
11, 15 Holding member
12 Expansion section
16 Concave portion
20 Insulating material
30 Heating member
41, 42 Shielding member
100 Manufacturing apparatus
A Atom
L1 First straight line
L2 Second straight line
L3 Third straight line
L4 Fourth straight line
L5 Fifth straight line
L6 Sixth straight line
p11, p21, p31, p41, p51, p61 First measurement point
p12, p22, p32, p42, p52, p62 Second measurement point
S1, S2, S3 Lattice surface

**Claims**

1. A SiC single crystal having a lattice surface measured along each of a first straight line, a second straight line, a third straight line, a fourth straight line, a fifth straight line and a sixth straight line, which is curved in a convex shape,

   wherein the lattice surface measured along each of the first straight line, the second straight line, the third straight line, the fourth straight line, the fifth straight line and the sixth straight line, has a center located closer to a C surface than an end portion of the lattice surface measured along each of the straight lines,
   the first straight line is a straight line passing through the center when seen in a plan view in a thickness direction,
   the second straight line is a straight line passing through the center and inclined 30° from the first straight line based on the center,
   the third straight line is a straight line passing through the center and inclined 60° from the first straight line based on the center,
   the fourth straight line is a straight line passing through the center and inclined 90° from the first straight line based on the center,
   the fifth straight line is a straight line passing through the center and inclined 120° from the first straight line based on the center, and
   the sixth straight line is a straight line passing through the center and inclined 150° from the first straight line based on the center.

2. The SiC single crystal according to claim 1, wherein a main surface has an offset angle with respect to a (0001) plane, and
   the first straight line is a straight line extending in a <11-20> direction.

3. The SiC single crystal according to claim 1 or 2, wherein, provided that a diameter when seen in a plan view in a thickness direction is d, a maximum diffraction peak angle of a (0004) plane at the center is $\omega_0$, and a maximum diffraction peak angle of the (0004) plane at a measurement point separated by d/3 from the center is $\omega_1$,
   in X-ray diffraction results measured along each of the first straight line, the second straight line, the third straight line, the fourth straight line, the fifth straight line and the sixth straight line, $(\omega_1-\omega_0)/(d/3) < -2.00\times10^{-6}$ is satisfied.

4. The SiC single crystal according to any one of claims 1 to 3, wherein, provided that a diameter when seen in a plan view in a thickness direction is d,
   in the X-ray diffraction results measured along each of the first straight line, the second straight line, the third straight line, the fourth straight line, the fifth straight line and the sixth straight line, a half width of a maximum diffraction peak in a (0004) plane at a measurement point separated by d/3 from the center is less than $5.20 \times 10^{-2}$.

5. The SiC single crystal according to any one of claims 1 to 4, wherein, provided that a basal plane dislocation density on a Si surface is $BPD_0$ and a basal plane dislocation density on a C surface is $BPD_1$, $(BPD_0-BPD_1)/BPD_0 > 64\%$ is satisfied.

6. The SiC single crystal according to any one of claims 1 to 5, wherein, provided that a threading screw dislocation density on a Si surface is $TSD_0$ and a threading screw dislocation density on a C surface is $TSD_1$, $(TSD_0-TSD_1)/TSD_0 > 48.2\%$ is satisfied.

7. The SiC single crystal according to any one of claims 1 to 6, wherein, provided that a basal plane dislocation density on a Si surface is $BPD_0$, a basal plane dislocation density on a C surface is $BPD_1$, a threading screw dislocation density on a Si surface is $TSD_0$, a threading screw dislocation density on a C surface is $TSD_1$, and a crystal length in a thickness direction is T,

$(BPD_0-BPD_1)/(BPD_0 \times T) > 1\%/mm$ is satisfied, and
$(TSD_0-TSD_1)/(TSD_0 \times T) > 1\%/mm$ is satisfied.

8. The SiC single crystal according to any one of claims 1 to 7, wherein a diameter when seen in a plan view in a thickness direction is equal to or greater than 145 mm.

9. The SiC single crystal according to any one of claims 1 to 8, wherein a diameter when seen in a plan view in a thickness direction is equal to or greater than 195 mm.

10. The SiC single crystal according to any one of claims 1 to 9, wherein a diameter when seen in a plan view in a thickness direction is equal to or greater than 295 mm.

11. The SiC single crystal according to any one of claims 1 to 10, wherein a basal plane dislocation density on a C surface is less than 500 pieces/cm$^2$.

12. The SiC single crystal according to any one of claims 1 to 11, wherein a threading screw dislocation density on a C surface is less than 300 pieces/cm$^2$.

13. The SiC single crystal according to any one of claims 1 to 12, wherein an etch pit density on a C surface is less than 4000 pieces/cm$^2$.

14. A SiC substrate comprising the SiC single crystal according to any one of claims 1 - 13.

15. A SiC epitaxial wafer comprising:

the SiC substrate according to claim 14; and
a SiC epitaxial layer formed on one surface of the SiC substrate.

FIG. 1

FIG. 2

FIG. 3

FIG. 4

## FIG. 5

S2

Z
Y
X

## FIG. 6

S3

Z
Y
X

# FIG. 7

# FIG. 8

# FIG. 9

# FIG. 10

Europäisches
Patentamt

European
Patent Office

Office européen
des brevets

# EUROPEAN SEARCH REPORT

Application Number

EP 25 18 9895

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YANG XIANGLONG ET AL: "Basal plane bending of 4H-SiC single crystals grown by sublimation method with different seed attachment methods - CrystEngComm (RSC Publishing)", CRYSTENGCOMM, vol. 20, no. 43, 1 January 2018 (2018-01-01), pages 6957-6962, XP093342660, GB ISSN: 1466-8033, DOI: 10.1039/C8CE00910D Retrieved from the Internet: URL:https://pubs.rsc.org/en/content/articl elanding/2018/ce/c8ce00910d> | 1-9,14, 15 | INV. C30B29/36 C30B23/06 |
| A | * "Experimental"; figures 1-7 * | 10-13 | |
| X | US 2020/010974 A1 (NAKABAYASHI MASASHI [JP] ET AL) 9 January 2020 (2020-01-09) | 1,2,8,9, 14,15 | |
| A | * paragraphs [0072], [0105] * | 3-7, 10-13 | TECHNICAL FIELDS SEARCHED (IPC) |
| A | JP 2020 026373 A (SHOWA DENKO KK; DENSO CORP) 20 February 2020 (2020-02-20) * paragraph [0028] * | 1-15 | C30B |
| X | US 2018/282902 A1 (NAKABAYASHI MASASHI [JP]) 4 October 2018 (2018-10-04) * paragraphs [0057], [0078], [0080], [0081], [0083], [0099]; table 1 * | 1,2, 11-13 | |
| A | EP 4 286 571 A1 (RESONAC CORP [JP]) 6 December 2023 (2023-12-06) * the whole document * | 1-15 | |

The present search report has been drawn up for all claims

| Place of search | Date of completion of the search | Examiner |
|---|---|---|
| The Hague | 17 December 2025 | Leibold, Joachim |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P4C01)

## ANNEX TO THE EUROPEAN SEARCH REPORT
## ON EUROPEAN PATENT APPLICATION NO.

EP 25 18 9895

This annex lists the patent family members relating to the patent documents cited in the above-mentioned European search report.
The members are as contained in the European Patent Office EDP file on
The European Patent Office is in no way liable for these particulars which are merely given for the purpose of information.

17-12-2025

| Patent document cited in search report | | Publication date | Patent family member(s) | | Publication date |
|---|---|---|---|---|---|
| US 2020010974 | A1 | 09-01-2020 | CN | 109196146 A | 11-01-2019 |
| | | | DE | 112018000035 T5 | 28-02-2019 |
| | | | JP | 6437173 B1 | 12-12-2018 |
| | | | JP | WO2018181788 A1 | 04-04-2019 |
| | | | US | 2020010974 A1 | 09-01-2020 |
| | | | WO | 2018181788 A1 | 04-10-2018 |
| JP 2020026373 | A | 20-02-2020 | JP | 7433586 B2 | 20-02-2024 |
| | | | JP | 7571902 B2 | 23-10-2024 |
| | | | JP | 2020026373 A | 20-02-2020 |
| | | | JP | 2024032023 A | 08-03-2024 |
| | | | WO | 2020036168 A1 | 20-02-2020 |
| US 2018282902 | A1 | 04-10-2018 | CN | 108138359 A | 08-06-2018 |
| | | | JP | WO2017057742 A1 | 19-07-2018 |
| | | | US | 2018282902 A1 | 04-10-2018 |
| | | | WO | 2017057742 A1 | 06-04-2017 |
| EP 4286571 | A1 | 06-12-2023 | CN | 117166055 A | 05-12-2023 |
| | | | EP | 4286571 A1 | 06-12-2023 |
| | | | JP | 7260039 B1 | 18-04-2023 |
| | | | JP | 2023177678 A | 14-12-2023 |
| | | | JP | 2023178210 A | 14-12-2023 |
| | | | KR | 20230167728 A | 11-12-2023 |
| | | | TW | 202400861 A | 01-01-2024 |
| | | | TW | 202509304 A | 01-03-2025 |
| | | | US | 2023392285 A1 | 07-12-2023 |
| | | | US | 2025146176 A1 | 08-05-2025 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024117184 A

- JP 2020026373 A